# EUROPÄISCHE PATENTANMELDUNG

(11) **EP 0 714 137 A1**
(43) Veröffentlichungstag der Anmeldung: **29.05.1996**
(21) Anmeldenummer: 95117712.0
(22) Anmeldetag: 09.11.1995
(51) Int. Cl.: H01L 29/73

(54) **Bipolartransistor auf SOI-Substrat**

(30) Priorität: 24.11.1994 DE 4441902
(71) Anmelder: SIEMENS AKTIENGESELLSCHAFT, D-80333 München (DE)
(72) Erfinder: Kerber, Martin, Dr., D-81827 München (DE); Mahnkopf, Reinhard, Dr., D-81479 München (DE)

(57) **Zusammenfassung**

Bipolartransistor mit aufeinanderfolgend einem Emitterbereich (1), einem Basisbereich (3) und einem Kollektorbereich (2) und lateral dazu Basis-Anschlußbereichen (7) in einer Mesa (4) in einer Body-Siliziumschicht eines SOI-Substrates, bei dem eine Polysiliziumschicht nach Art einer für MOSFETs vorgesehenen Gate-Elektrode mit einem streifenförmigen Anteil auf dem Basisbereich (3) vorhanden ist, die für denselben Leitfähigkeitstyp wie der Basisbereich (3) dotiert und gemeinsam mit dem Basis-Anschlußbereich (7) mit einem Kontakt (8) versehen ist. Aufgrund der gleichnamigen Dotierung dieser Polysiliziumschicht (5) mit der Basis wird im Basisbereich nur eine sehr dünne Verarmungszone ausgebildet, so daß eine möglichst große Querschnittsfläche für den Emitter-Kollektor-Strom zur Verfügung steht.

## Beschreibung

Die vorliegende Erfindung betrifft einen Bipolartransistor auf SOI-Substrat, insbesondere für Herstellung im Rahmen eines CBiCMOS-Prozesses.

Die gemeinsame Integration von Bipolartransistoren und MOS-Transistoren auf einem Siliziumwafer ermöglicht, die Vorteile beider Techniken für Schaltungsanwendungen zu nutzen. Insbesondere bei SOI-Substraten (Silicon on Insulator) bietet sich die gemeinsame Realisierung von komplementären lateralen Bipolartransistoren sowie MOS-Transistoren an, da Struktur und Prozeßfolge sehr ähnlich sind. Bei einem SOI-Substrat ist eine dünne Nutzschicht aus Silizium, die sog. Body-Siliziumschicht, durch eine Isolatorschicht (z. B. Oxid) von dem restlichen Substrat, dem sog. Bulk, aus Silizium getrennt.

Ansätze für laterale Bipolartransistoren auf SOI-Substrat erfordern anspruchsvolle Lithographie, wenn die Basis durch Implantationsmasken realisiert wird, oder benötigen zusätzlichen Prozeßaufwand.

Aufgabe der vorliegenden Erfindung ist es, einen Bipolartransistor auf SOI-Substrat, der mit einem CMOS-Prozeß kompatibel herstellbar ist, und ein zugehöriges Herstellungsverfahren anzugeben.

Diese Aufgabe wird mit dem Bipolartransistor mit den Merkmalen des Anspruches 1 und mit dem Herstellungsverfahren mit den Merkmalen des Anspruches 7 gelöst. Weitere Ausgestaltungen ergeben sich aus den abhängigen Ansprüchen.

Bei dieser Erfindung wird ein lateraler Bipolartransistor auf der Oberseite eines Basisbereiches mit einer von diesem Basisbereich durch eine Dielektrikumschicht elektrisch isolierten strukturierten Schicht versehen. Die Herstellung dieses Transistors ist vollständig kompatibel mit dem CMOS-Prozeß, wenn für diese strukturierte Schicht ein Anteil einer für die Gate-Elektroden eines gleichzeitig hergestellten MOSFETs vorgesehenen Schicht verwendet wird. Diese Schicht dient dann als Maske für eine selbstjustierte Implantation von Emitter und Kollektor. Der von dieser strukturierten Schicht als Maske abgeschirmte Bereich behält eine für die Basis vorgesehene Grunddotierung. Die strukturierte Schicht wird elektrisch leitend dotiert, und für eine möglichst kleine parasitäre Kapazität ist diese strukturierte Schicht mit dem Potential der darunter angeordneten Basis verbunden. Durch eine geeignete Dotierung dieser Schicht ist bei diesem Bipolartransistor erreicht, daß eine möglichst dünne Verarmungszone in dem Basisbereich vorhanden ist, um den Kollektorstrom möglichst wenig einzugrenzen. Durch die erfindungsgemäße Strukturierung und geeignete Wahl der Dotierungen ist der Bipolartransistor voll kompatibel mit dem CMOS-Prozeß.

Es folgt eine Beschreibung des erfindungsgemäßen Bipolartransistors anhand der beiden beigefügten Figuren.
- Figur 1: zeigt einen erfindungsgemäßen Bipolartransistor in Aufsicht.
- Figur 2: zeigt den Transistor der Figur 1 in dem eingezeichneten Schnitt.

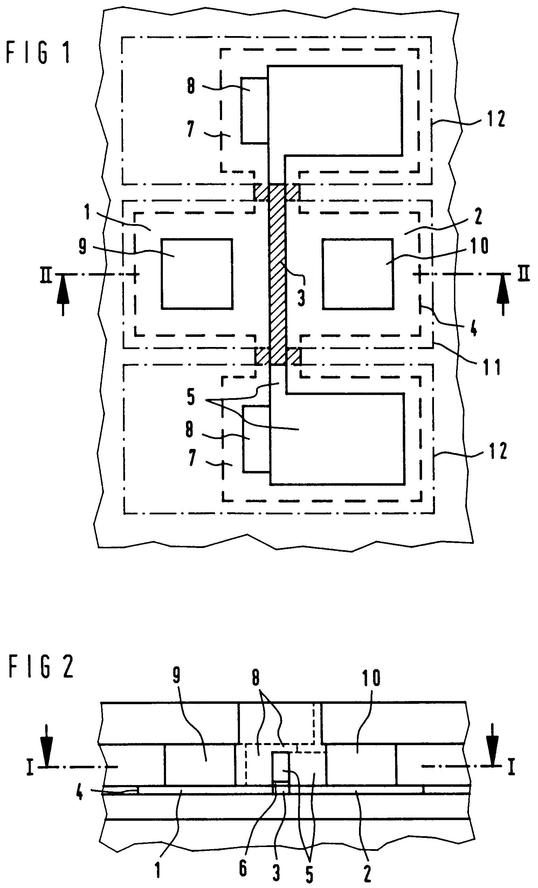

Bei dem erfindungsgemäßen Bipolartransistor wird ein ringsum elektrisch isolierter Bereich in einer Body-Siliziumschicht hergestellt. Dieser Bereich kann z. B. durch eine in Figur 1 als verdeckte Kontur gestrichelt eingezeichnete Mesa 4 gebildet werden. Rings um diese Mesa 4 ist das Silizium der Body-Siliziumschicht bis zur darunter befindlichen Isolatorschicht des SOI-Substrates entfernt. Als Alternative kommt eine LOCOS-Isolation in der Body-Siliziumschicht ringsum den für den Bipolartransistor vorgesehenen Bereich in Frage. In diesem Bereich, bei diesem Ausführungsbeispiel also die Mesa 4, ist eine Grunddotierung für den Basisbereich 3 eingebracht. Auf der Oberseite der Mesa befindet sich eine strukturierte Schicht 5 z. B. aus Polysilizium, die entsprechend den Gate-Elektroden der ggf. mit demselben Prozeß hergestellten MOSFETs auf eine Dielektrikumschicht aufgebracht und strukturiert wird. Bei der Herstellung des Bipolartransistors wird unter Verwendung dieser strukturierten Schicht 5 als Maske eine Implantierung von Dotierstoff für elektrische Leitfähigkeit des Emitters bzw. Kollektors in dem in Figur 1 strichpunktiert eingezeichneten Bereich 11 eingebracht. Auf diese Weise werden ein Emitterbereich 1 und ein Kollektorbereich 2 lateral an den Basisbereich 3 angrenzend hergestellt. Die Dosis dieser Implantierung wird dabei so hoch gewählt, daß die ursprüngliche Grunddotierung umdotiert wird und nur noch der schraffiert eingezeichnete Bereich diese Grunddotierung aufweist.

In den strichpunktiert umrandeten Bereichen 12 auf beiden Seiten dieses von dem Emitterbereich 1, dem Kollektorbereich 2 und dem Basisbereich 3 eingenommenen Bereiches und vorzugsweise in einem Abstand dazu sind Implantierungen für den Leitfähigkeitstyp der Basis eingebracht und hoch dotierte Anschlußbereiche 7 für die Basis ausgebildet. Auf diesen Basis-Anschlußbereichen 7 befindet sich je ein Kontakt 8 für den Basisanschluß. Dieser Kontakt 8 ist teilweise auf der strukturierten Schicht 5 aufgebracht, so daß die Basis-Anschlußbereiche 7 in dem Body-Silizium und die darüber aufgebrachte strukturierte Schicht 5 elektrisch leitend verbunden und damit auf demselben Potential sind. Wenn für die strukturierte Schicht 5 Polysilizium verwendet wird, dann wird durch einen Temperschritt zum Aktivieren der eingebrachten Dotierstoffe dafür gesorgt, daß die durch die Implantierungen in den Bereichen 12 eingebrachte Dotierung hoher Dichte aus den im Bereich 12 befindlichen Anteilen dieser strukturierten Schicht 5 sehr rasch in den schmalen, auf dem Basisbereich 3 vorhandenen Anteil dieser strukturierten Schicht 5 ausdiffundiert, so daß der Anteil dieser strukturierten Schicht 5 auf dem Basisbereich 3 dasselbe Vorzeichen der Dotierung hat wie der Basisbereich 3. Das steht im Gegensatz zu MOSFETs, bei denen üblicherweise die Gate-Elektrode das entgegengesetzte Vorzeichen der Leitfähigkeit hat wie der darunter liegende Kanalbereich.

Auf dem Emitterbereich 1 und dem Kollektorbereich 2 sind ebenfalls je ein Kontakt 9, 10 für den elektrischen Anschluß aufgebracht. Die Oberseite des Transistors kann z. B. mit einer Dielektrikumschicht planarisiert sein. Vorteilhaft sind zwei Basis-Anschlußbereiche 7 wie beschrieben; wegen der guten elektrischen Leitfähigkeit der strukturierten Schicht 5 genügt aber ein Basis-Anschlußbereich 7 auf einer Seite.

Figur 2 zeigt den in Figur 1 eingezeichneten Querschnitt. Der Emitterbereich 1 der Kollektorbereich 2 und der Basisbereich 3 sind eingezeichnet als Teil der Mesa 4. Zwischen der strukturierten Schicht 5 und dem Basisbereich 3 ist die Dielektrikumschicht 6 eingezeichnet. Diese Dielektrikumschicht 6 ist hier nur unter der strukturierten Schicht 5 vorhanden, was in erster Linie die Darstellung vereinfacht. Bei einfachen Ausführungsformen bleibt die anfangs ganzflächig vorhandene Dielektrikumschicht 6 bis auf für die Kontakte 8, 9, 10 erforderliche Öffnungen stehen. Der sich auf dem in Blickrichtung hinteren Basis-Anschlußbereich 7 nach rechts erweiternde Anteil der strukturierten Schicht 5 ist als verdeckte Kontur mit einer waagrechten gestrichelten Linie eingezeichnet. Dieser Anteil der strukturierten Schicht muß nicht ausschließlich auf dem Basis-Anschlußbereich 7 aufgebracht sein. Weitere gestrichelte Linien sind die verdeckten Kontur des teilweise auf dem Basis-Anschlußbereich 7 und teilweise auf der strukturierten Schicht 5 aufgebrachten Kontaktes 8 für den Basisanschluß. Auf den Kontakten 8, 9, 10 ist noch eine erste Metallisierungsebene angedeutet. Die Zwischenräume sind hier z. B. mit einem Dielektrikum aufgefüllt und planarisiert. Im Gegensatz zu den MOSFETs erfolgt bei dem erfindungsgemäßen Bipolartransistor die Stromzuführung in die Basis sowie den darüber angeordneten schmalen Anteil der strukturierten Schicht 5 vorzugsweise von beiden Seiten, weshalb beidseitig der Basis hoch dotierte Basis-Anschlußbereiche 7 vorhanden sind. Wegen der Dotierung der strukturierten Schicht 5 mit gleichem Vorzeichen wie der Basisbereich bildet sich im Basisbereich eine dünne Verarmungszone (nahezu Flatband-Bedingung), so daß der parasitäre MOS-Transistor eine hohe Einsatzspannung aufweist. Selbst bei großem Basisbahnwiderstand tritt bei dem Einsatz des Transistors in einer Schaltung daher nicht eine einem MOSFET entsprechende Funktion auf.

## Patentansprüche

1. Lateraler Bipolartransistor in Silizium,
bei dem ein dotierter Emitterbereich (1), ein dotierter Kollektorbereich (2), dazwischen ein für den entgegengesetzten Leitfähigkeitstyp dotierter Basisbereich (3) und ein hoch dotierter Basis-Anschlußbereich (7), der elektrisch leitend mit diesem Basisbereich (3) verbunden ist, ausgebildet sind,
bei dem sich konform zu den Begrenzungen dieses Basisbereiches (3) zu diesem Emitterbereich (1) und zu diesem Kollektorbereich (2) hin über diesem Basisbereich (3) eine strukturierte Schicht (5) befindet,
bei dem zwischen dieser strukturierten Schicht (5) und diesem Basisbereich (3) eine dünne Dielektrikumschicht (6) vorhanden ist und
bei dem diese strukturierte Schicht (5) für denselben Leitfähigkeitstyp wie der Basisbereich (3) dotiert ist.

2. Bipolartransistor nach Anspruch 1,
bei dem die strukturierte Schicht (5) einen Teil des Basis-Anschlußbereiches (7) bedeckt und
bei dem ein für die Basis vorgesehener Kontakt (8) so auf diesem Basis-Anschlußbereich (7) aufgebracht ist, daß dieser Kontakt (8) gleichzeitig die strukturierte Schicht (5) kontaktiert.

3. Bipolartransistor nach Anspruch 1 oder 2,
bei dem auf zwei einander gegenüberliegenden Seiten des Basisbereiches (3) je ein Basis-Anschlußbereich (7) vorhanden ist.

4. Bipolartransistor nach einem der Ansprüche 1 bis 3,
bei dem die Dotierung der strukturierten Schicht (5) so eingestellt ist, daß in dem Basisbereich (3) nicht mehr als eine sehr dünne Schicht an Ladungsträgern verarmt ist.

5. Bipolartransistor nach einem der Ansprüche 1 bis 4,
bei dem der Emitterbereich (1), der Kollektorbereich (2), der Basisbereich (3) und der Basis-Anschlußbereich (7) die Dicke einer Body-Siliziumschicht besitzen und sich auf der Isolationsschicht eines SOI-Substrates befinden.

6. Bipolartransistor nach einem der Ansprüche 1 bis 5,
bei dem die strukturierte Schicht (5) Polysilizium ist.

7. Verfahren zur Herstellung eines Bipolartransistors nach einem der Ansprüche 1 bis 6, bei dem
in einem ersten Schritt ein für den Bipolartransistor vorgesehener Bereich in einer Body-Siliziumschicht eines SOI-Substrates ringsum elektrisch isoliert und mit einer für den Basisbereich (3) vorgesehenen Grunddotierung und mit einer dünnen Dielektrikumschicht (6) an seiner Oberfläche versehen wird,
in einem zweiten Schritt eine für die strukturierte Schicht (5) vorgesehene Schicht aufgebracht und strukturiert wird, in einem dritten Schritt unter Verwendung von Masken Implantierungen von Dotierstoffen für den Emitterbereich (1) und den Kollektorbereich (2) sowie für den Basis-Anschlußbereich (7) und die strukturierte Schicht (5) erfolgen und
in einem vierten Schritt diese Dotierstoffe aktiviert und Kontakte hergestellt werden.

8. Verfahren nach Anspruch 7, bei dem
in dem zweiten Schritt die strukturierte Schicht (5) mit einem Anteil auf dem Basis-Anschlußbereich (7) hergestellt wird,
in dem dritten Schritt dieser Anteil der strukturierten Schicht (5) zusammen mit dem Basis-Anschlußbereich (7) so hoch dotiert wird, daß in dem nachfolgenden vierten Schritt durch Diffusion des Dotierstoffes in den über dem Basisbereich (3) aufgebrachten Anteil der strukturierten Schicht (5) die dafür vorgesehene Dotierung hergestellt werden kann.

9. Verfahren nach Anspruch 7 oder 8, bei dem
in dem dritten Schritt die Implantierung für den Emitterbereich (1) und den Kollektorbereich (2) gemeinsam erfolgt, wobei der Basisbereich (3) durch die strukturierte Schicht (5) abgeschirmt wird, und die Dosis der in die strukturierte Schicht (5) eingebrachten Implantierung so hoch eingestellt wird, daß nach dem vierten Schritt die strukturierte Schicht (5) auch in dem über dem Basisbereich (3) befindlichen Anteil den für die Basis vorgesehenen Leitfähigkeitstyp aufweist.
